# EUROPEAN PATENT APPLICATION

(11) **EP 3 343 578 A1**
(43) Date of publication of application: **04.07.2018**
(21) Application number: 17211134.6
(22) Date of filing: 29.12.2017
(51) Int. Cl.: H01G 9/20

(54) **WORKING ELECTRODE OF DYE-SENSITIZED SOLAR CELL**

(30) Priority: 30.12.2016 KR 20160184451; 13.10.2017 KR 20170133495
(71) Applicant: Dongjin Semichem Co., Ltd, Incheon 22824 (KR)
(72) Inventor: YANG, Hwi Chan, 13486 Gyeonggi-do (KR); KIM, Jong Bok, 13486 Gyeonggi-do (KR); BAEK, Jong Gyu, 13486 Gyeonggi-do (KR); KIM, Young Mi, 13486 Gyeonggi-do (KR); SHIN, Kyusoon, 13486 Gyeonggi-do (KR)
(74) Representative: Grünecker Patent- und Rechtsanwälte PartG mbB

(57) **Abstract**

The present invention relates to a dye-sensitized solar cell electrode, and more particularly, to a dye-sensitized solar cell electrode capable of enhancing a bond between a dye and a oxide semiconductor to secure reliability and efficiency of a dye-sensitized solar cell.

## Description

### [Technical Field]

The present invention relates to a working electrode of a dye-sensitized solar cell, and more particularly, to a working electrode of a dye-sensitized solar cell capable of enhancing a bond between a dye and a oxide semiconductor to secure reliability and efficiency of a dye-sensitized solar cell.

### [Background Art]

Contents described below merely provide background information related to the present invention and do not constitute the conventional art.

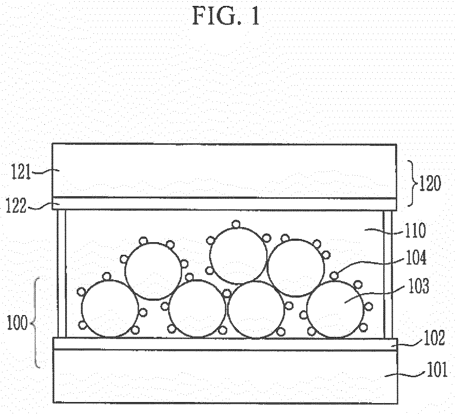

As shown in FIG. 1A dye-sensitized solar cell includes, as main components, a conductive substrate (a substrate 101 on which a conductive film 102 is formed), a oxide semiconductor 103, a dye 104, an electrolyte 110, and a counter electrode 120 (a substrate 121 on which an electrode material 122 is formed). The dye 104 is adsorbed onto the oxide semiconductor 103 and electrons excited by light are injected into the oxide semiconductor 103 to drive the dye-sensitized solar cell.

Conventionally, the adsorption between the dye 104 and the oxide semiconductor 103 is performed through a immersing method, and the immersing method has a disadvantage in that the working electrode is damaged and a large number of physical bonds between the dyes 104 occur due to prolonged immersing time.

Particularly, the physical bond by aggregation between the dyes 104 causes a phenomenon that the dye 104 is separated into the electrolyte 110 when the dye-sensitized solar cell is driven at a high temperature. Most of the separated dyes 104 float in the electrolyte 110, but some of the dyes 104 again form a bond with the oxide semiconductor 103 or form a bond with the conductive film substrate 102. In particular, when a bond with a counter electrode material 122 is formed, a redox reaction between the electrolyte 110 and the counter electrode 120 is affected, and thus, a fill factor (FF) is lowered and efficiency is greatly reduced.

### [DISCLOSURE]

### [Technical Problem]

The present invention has been made in an effort to provide a working electrode of a dye-sensitized solar cell having advantages of enhancing a bond between a dye and a oxide semiconductor to prevent the dye from being separated from the oxide semiconductor, and securing reliability and efficiency of a dye-sensitized solar cell.

### [Technical Solution]

An exemplary embodiment of the present invention provides a dye-sensitized solar cell capable of securing reliability and efficiency by including the working electrode of the dye-sensitized solar cell.

Another embodiment of the present invention provides a working electrode of a dye-sensitized solar cell including:
a oxide semiconductor; and a dye having two or more anchoring groups, wherein the two or more anchoring groups of the dye are bonded to the oxide semiconductor.

According to an embodiment of the present invention, a ratio at which the two or more anchoring groups of the dye are bonded to the oxide semiconductor may be 60% or more of an entire dye.

According to an embodiment of the present invention, a ratio at which the two or more anchoring groups of the dye are bonded to the oxide semiconductor may be 80% or more of an entire dye.

According to an embodiment of the present invention, a ratio at which the two or more anchoring groups of the dye are bonded to the oxide semiconductor may be 90% or more of an entire dye.

According to an embodiment of the present invention, the oxide semiconductor may be titanium dioxide (TiO₂).

According to an embodiment of the present invention, the anchoring group of the dye may be any one selected from the group consisting of a carboxyl group (-COOH), a cyanoacrylic acid group, an alkoxysilyl group, a pyridine group, a phosphonic acid group, a tetracyanate group, a perylene dicarboxylic acid anhydride group, a 2-hydroxylbenzonitrile group, a 8-hydroxylquinoline group, a pyridine-N-oxide group, a hydroxylpyridium group, a catechol group, a hydroxamate group, a sulfonic acid group, an acetylacetanate group, a boronic acid group, a nitro group, a tetrazole group, a rhodamine group, and a salicylic acid group.

According to an embodiment of the present invention, the dye may be a metal complex dye or an organic dye.

Another embodiment of the present invention provides a dye-sensitized solar cell including: the working electrode as described above.

Another embodiment of the present invention provides a manufacturing method of the working electrode as described above.

### [Advantageous Effects]

According to the present invention, the bond between the dye and the oxide semiconductor may be enhanced to prevent the dye from being separated from the oxide semiconductor, and to secure reliability and efficiency of the dye-sensitized solar cell.

### [Description of the Drawings]

FIG. 1 shows a general structure of a dye-sensitized solar cell.
FIG. 2 shows FT-IR analysis results of a working electrode on which a oxide semiconductor is deposited.
FIG. 3 shows FT-IR analysis results of a working electrode including a oxide semiconductor onto which a dye is adsorbed by a conventional immersing method.
FIG. 4 shows FT-IR analysis results of a working electrode including a oxide semiconductor onto which a dye is adsorbed according to an exemplary embodiment of the present invention
FIG. 5 is a schematic diagram for explaining a method of adsorbing a dye onto a oxide semiconductor by electric field adsorption according to an exemplary embodiment of the present invention.

### [Mode for Invention]

In the following detailed description, only certain exemplary embodiments of the present invention have been shown and described, simply by way of illustration. As those skilled in the art would realize, the described embodiments may be modified in various different ways, all without departing from the spirit or scope of the present invention.

In addition, unless explicitly described to the contrary, the word "comprise" and variations such as "comprises" or "comprising", will be understood to imply the inclusion of stated elements but not the exclusion of any other elements.

A working electrode 100 of a dye-sensitized solar cell of the present invention includes a oxide semiconductor 103; and a dye 104 having two or more anchoring groups, wherein the two or more anchoring groups of the dye 104 are bonded to the oxide semiconductor 103.

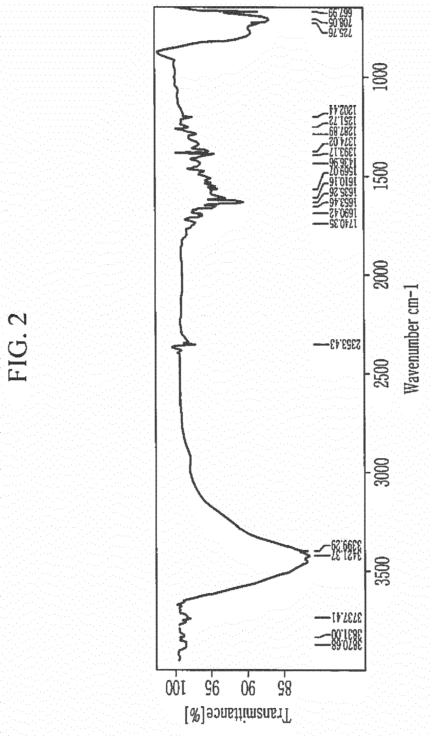

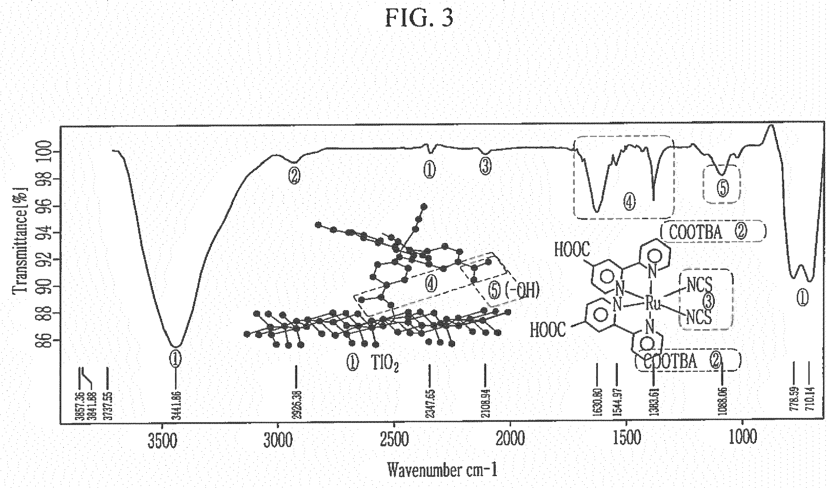

The working electrode 100 of the dye-sensitized solar cell is manufactured by depositing a conductive film 102 on a working electrode substrate 101, then depositing the oxide semiconductor 103 on the conductive film 102, and immersing the working electrode on which the oxide 103 is deposited on a dye solution in which the dye 104 is dissolved to thereby adsorb the dye 104 onto the oxide 103. In general, the FT-IR analysis results of the working electrode 100 including the oxide semiconductor 103 deposited on the conductive film 102 are shown in FIG. 2, and the FT-IR analysis results of the working electrode 100 including the oxide 103 onto which the dye 104 is adsorbed through a conventional immersing method are shown in FIG. 3. When the dye 104 is adsorbed onto the oxide semiconductor 103 through the general immersing method, an adsorption time is required to be 12 hours or more, and thus, the working electrode 100 may be damaged due to immersing on the dye solution for a long time, and as shown in FIG. 3, only one of the two anchoring groups included in the dye 104 bonds with the oxide 103, and thus, a binding force between the dye 104 and the oxide 103 is weaken, and the bond between the dyes is formed.

On the other hand, in the working electrode 100 of the dye-sensitized solar cell of the present invention, a ratio at which the two or more anchoring groups of the dye 104 are bonded to the oxide semiconductor 103 may be 60% or more of an entire dye 104. Preferably, a ratio at which the two or more anchoring groups of the dye 104 are bonded to the oxide semiconductor 103 may be 80% or more of an entire dye 104. More preferably, a ratio at which the two or more anchoring groups of the dye 104 are bonded to the oxide semiconductor 103 may be 90% or more of an entire dye 104.

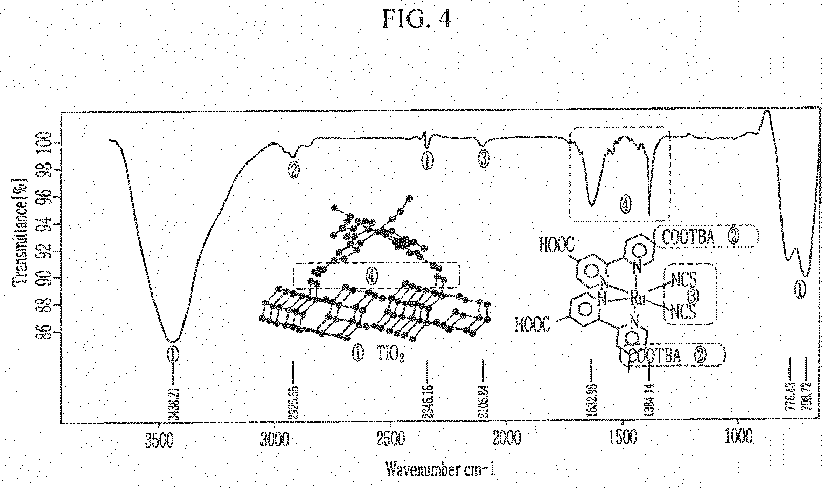

The description that the ratio at which the two or more anchoring groups of the dye are bonded to the oxide semiconductor is several % or more of the entire dye means a probability that there is almost no -OH peak that is not bonded with titanium dioxide at the anchoring group of the dye, as a result of spot sampling on any 10 points of a dye-sensitized solar cell module including the working electrode 100, and measuring FT-IR thereon as shown in FIG. 4.

Specifically, FIG. 4 shows FT-IR measured after the working electrode 100 is manufactured by using a working electrode substrate 101 on which titanium dioxide is formed as the oxide semiconductor 103, using a ruthenium-based dye as the dye 104, and applying an electric field to adsorb the dye. As shown in FIG. 4, it may be appreciated that -OH peak (□ peak in FIG. 3) of the ruthenium-based dye that is not bonded with titanium dioxide is hardly shown.

The manufacturing method of the working electrode 100 will be described in detail. The working electrode 100 may be manufactured by applying a voltage to a dye solution in which the dye 104 including the two or more anchoring groups is dissolved, and immersing the working electrode 100 in which the conductive film 102 and the oxide semiconductor 103 are sequentially deposited on the substrate 101 on the dye 104 solution to adsorb the dye 104 onto the oxide semiconductor 103 through electric field adsorption.

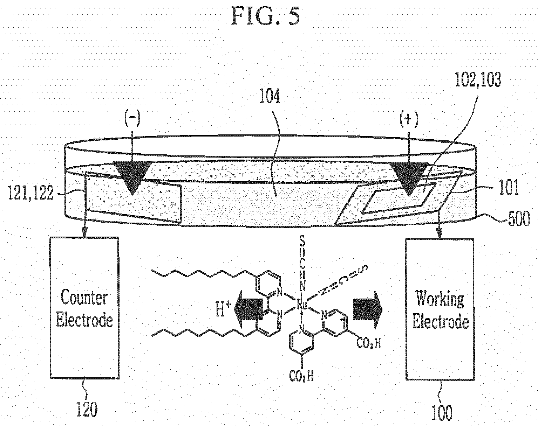

In detail, the working electrode 100 and a conductive counter electrode 120 are prepared, the working electrode 100 including the conductive film 102 and the oxide semiconductor 103 sequentially formed on the working electrode substrate 101 and the conductive counter electrode 120 including an electrode material 122 formed on a counter electrode substrate 121. When the counter electrode substrate 121 itself is conductive, the electrode material 122 is not required to be formed, and other types of conductive substrates may be used in place of the counter electrode 120. Then, the solution in which the dye 104 is dissolved is prepared, and the dye solution is filled in a bath 500 as shown in FIG. 5.

Subsequently, after the working electrode 100 and the counter electrode 120 are supported on the bath 500, a (+) voltage is applied to the working electrode 100 and a (-) voltage is applied to the counter electrode 120, and thus, the dye 104 is adsorbed onto the oxide 103. The voltage V to be applied may be 100V or less, preferably 10V or less. In this case, a temperature of the solution may be 25 to 60□, preferably 50 to 60□, and an adsorption time may be 10 minutes to 1 hour, preferably 30 minutes to 1 hour, but the temperature of the solution and the adsorption time are not limited thereto. When the electric field adsorption is performed as described above, the dye 104 is bonded to the oxide semiconductor 103, and in the bonded dye 104, the two or more anchoring groups are bonded to the oxide semiconductor 103.

In the working electrode 100 of the present invention, the oxide semiconductor 103 is not particularly limited, but specifically, may be titanium dioxide (TiO₂).

Further, the anchoring group of the dye 104 in the working electrode 100 of the present invention is not particularly limited, but specifically, the anchoring group of the dye may be configured of a material including two or more of any one selected from the group consisting of a carboxyl group (-COOH), a cyanoacrylic acid group, an alkoxysilyl group, a pyridine group, a phosphonic acid group, a tetracyanate group, a perylene dicarboxylic acid anhydride group, a 2-hydroxylbenzonitrile group, a 8-hydroxylquinoline group, a pyridine-N-oxide group, a hydroxylpyridium group, a catechol group, a hydroxamate group, a sulfonic acid group, an acetylacetanate group, a boronic acid group, a nitro group, a tetrazole group, a rhodamine group, and a salicylic acid group.

Further, in the working electrode 100 of the present invention, the dye 104 is not particularly limited as long as it is a dye 104 having two or more anchoring groups that are usable in the dye-sensitized solar cell. Specifically, the dye may be a metal complex dye or an organic dye. Examples of the metal complex dye may include a ruthenium-based dye, and may include a material represented by Chemical Formula below:

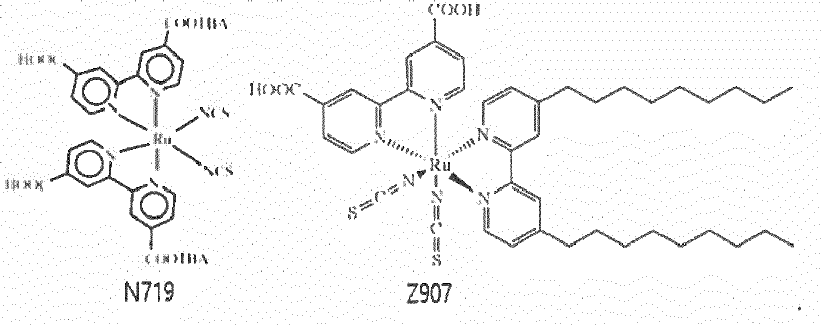

The above Chemical Formula is an example of the dye 104, and various dyes are disclosed in "ACS Appl. Mater. Interfaces 2015, 7, 3427-3455 "Anchoring Groups for Dye-Sensitized Solar Cells", the disclosures of which are incorporated herein by reference.

Further, the present invention also provides a dye-sensitized solar cell including the working electrode 100, and thus, according to the present invention, the dye 104 may be strongly bonded to the oxide semiconductor 103, and thus, the dye 104 may be prevented from being separated from the oxide semiconductor 103, the bond between the dyes 104 may be prevented, and the damage of the working electrode 100 may be minimized to increase the filling factor of the dye-sensitized solar cell and to increase the efficiency, thereby securing reliability and efficiency.

Hereinafter, preferred Examples are presented in order to help a better understanding of the present invention, however, the following Examples are only illustrative of the present invention, and do not limit the scope of the present invention.

### Assembly of dye-sensitized solar cell

Dye-sensitized solar cells including (1) a working electrode in which the dye was adsorbed by simple immersing without applying the voltage, (2) a working electrode in which the dye was adsorbed through electric field adsorption by applying the voltage of 5V for 60 minutes, (3) a working electrode in which the dye was adsorbed through electric field adsorption by applying the voltage of 10V for 60 minutes, and (4) a working electrode in which the dye was adsorbed through electric field adsorption by applying the voltage of 11V for 60 minutes, respectively, wherein each working electrode included titanium dioxide as the conductor oxide, and cis-Bis(isothiocyanato)(2,2'-bipyridyl-4,4'-dicarboxylato)(4,4'-di-nonyl-2'-bipyridyl)ruthenium(II) as the dye, were assembled, respectively.

### Characteristic analysis according to applied voltage

Photoelectric performance of each assembled dye-sensitized solar cell was evaluated by measuring a photocurrent density and a voltage (J-V). The short-circuit current density (Jsc), the open-circuit voltage (Voc), and the fill factor (FF) were extracted from the J-V profile. The efficiency (η) was measured according to the relationship η=Jsc×Voc×FF/(100 mWcm-2). The measurement was performed after passing 36 hours, 450 hours, and 850 hours, respectively, at 85 immediately after the assembly.

The measured results are shown in Tables 1 to 7 below. Table 1 shows a simple immersing case, Table 2 shows a case where a voltage of 5V was applied, Table 3 shows a case where a voltage of 10V was applied, Table 4 shows a case where a voltage of 11V was applied, Table 5 shows a case where a voltage of 50V was applied, Table 6 shows a case where a voltage of 100V was applied, and Table 7 shows a case where a voltage of 105V was applied, respectively.

**[Table 1]**

| Storage time at high temperature of 85□ | Jsc (mA/cm²) | Voc (V) | F. F (%) | Efficiency (%) |
|---|---|---|---|---|
| 0h | 10.64 | 0.696 | 77.56 | 5.74 |
| 36h | 10.8 | 0.663 | 76.36 | 5.47 |
| 450h | 10.92 | 0.663 | 74.07 | 5.36 |
| 850h | 10.28 | 0.62 | 76.18 | 4.86 |
| Variation ratio (%) | -3.4 | -10.9 | -1.8 | -15.3 |

**[Table 2]**

| Storage time at high temperature of 85□ | Jsc (mA/cm²) | Voc (V) | F. F (%) | Efficiency (%) |
|---|---|---|---|---|
| 0h | 11.04 | 0.695 | 77.66 | 5.96 |
| 36h | 11.52 | 0.688 | 75.78 | 6.01 |
| 450h | 11.6 | 0.69 | 75.18 | 6.02 |
| 850h | 11.6 | 0.65 | 75.54 | 5.7 |
| Variation ratio (%) | 5.1 | -6.5 | -2.7 | -4.4 |

**[Table 3]**

| Storage time at high temperature of 85□ | Jsc (mA/cm²) | Voc (V) | F. F (%) | Efficiency (%) |
|---|---|---|---|---|
| 0h | 10.8 | 0.728 | 74 | 5.82 |
| 36h | 11.16 | 0.708 | 73.21 | 5.78 |
| 450h | 11.08 | 0.721 | 70.74 | 5.65 |
| 850h | 11.04 | 0.688 | 71.13 | 5.4 |
| Variation ratio (%) | 2.2 | -5.5 | -3.9 | -7.2 |

**[Table 4]**

| Storage time at high temperature of 85□ | Jsc (mA/cm2) | Voc (V) | F. F (%) | Efficiency (%) |
|---|---|---|---|---|
| 0h | 10.7 | 0.729 | 73.90 | 5.76 |
| 36h | 10.8 | 0.72 | 73.01 | 5.68 |
| 450h | 10.7 | 0.71 | 70.60 | 5.36 |
| 850h | 10.6 | 0.68 | 70.40 | 5.07 |
| Variation ratio (%) | -0.9 | -6.7 | -4.7 | -12.0 |

**[Table 5]**

| Storage time at high temperature of 85□ | Jsc (mA/cm2) | Voc (V) | F. F (%) | Efficiency (%) |
|---|---|---|---|---|
| 0h | 10.7 | 0.73 | 73.80 | 5.76 |
| 36h | 10.7 | 0.723 | 73.10 | 5.65 |
| 450h | 10.6 | 0.712 | 70.70 | 5.33 |
| 850h | 10.5 | 0.677 | 70.40 | 5 |
| Variation ratio (%) | -1.9 | -7.3 | -4.6 | -13.2 |

**[Table 6]**

| Storage time at high temperature of 85□ | Jsc (mA/cm2) | Voc (V) | F. F (%) | Efficiency (%) |
|---|---|---|---|---|
| 0h | 10.6 | 0.729 | 74.30 | 5.74 |
| 36h | 10.6 | 0.722 | 73.40 | 5.62 |
| 450h | 10.5 | 0.712 | 70.60 | 5.28 |
| 850h | 10.4 | 0.674 | 70.40 | 4.93 |
| Variation ratio (%) | -1.9 | -7.5 | -5.2 | -14.1 |

**[Table 7]**

| Storage time at high temperature of 85□ | Jsc (mA/cm2) | Voc (V) | F. F (%) | Efficiency (%) |
|---|---|---|---|---|
| 0h | 10.5 | 0.73 | 73.80 | 5.66 |
| 36h | 10.4 | 0.724 | 73.10 | 5.5 |
| 450h | 10.3 | 0.711 | 70.70 | 5.12 |
| 850h | 10.2 | 0.67 | 70.40 | 4.81 |
| Variation ratio (%) | -2.9 | -8.2 | -4.6 | -15.0 |

It could be appreciated that when the voltage of 100V or less was applied (Tables 2 to 6), the reduction rate of efficiency was entirely reduced as compared to the simple immersing case and the case where the voltage of 105 V was applied (Table 1 and Table 7).

In particular, it could be appreciated that the reduction rate of efficiency was reduced by 1/4 to 1/2 in the case where the voltage of 10V or less was applied (Tables 2 and 3).

### Characteristic analysis according to adsorption amount

The short-circuit current density (Jsc), the open-circuit voltage (Voc), and the fill factor (FF) were measured, and the efficiency was calculated on cases where the ratio at which the two or more anchoring groups of the dye were bonded to the titanium dioxide was 60%, 80%, 90%, and 50% in the entire dye, among the previously assembled dye-sensitized solar cells.

Results thereof are shown in Table 8 below (electric field adsorption amount of 60%), Table 9 below (electric field adsorption amount of 80%), Table 10 below (electric field adsorption amount of 90%), and Table 11 below (electric field adsorption amount of 50%).

**[Table 8]**

| Storage time at high temperature of 85□ | Jsc (mA/cm²) | Voc (V) | F. F (%) | Efficiency (%) |
|---|---|---|---|---|
| 0h | 10.92 | 0.694 | 77.6 | 5.88 |
| 36h | 11.12 | 0.688 | 76.3 | 5.84 |
| 450h | 11.04 | 0.685 | 74.88 | 5.66 |
| 850h | 11.02 | 0.66 | 75.5 | 5.49 |
| Variation ratio (%) | 0.9 | -4.9 | -2.7 | -6.6 |

**[Table 9]**

| Storage time at high temperature of 85□ | Jsc (mA/cm²) | Voc (V) | F. F (%) | Efficiency (%) |
|---|---|---|---|---|
| 0h | 10.98 | 0.695 | 77.5 | 5.91 |
| 36h | 11.14 | 0.688 | 76.5 | 5.86 |
| 450h | 11.07 | 0.685 | 75.7 | 5.74 |
| 850h | 11.06 | 0.672 | 75.6 | 5.62 |
| Variation ratio (%) | 0.7 | -3.3 | -2.5 | -4.9 |

**[Table 10]**

| Storage time at high temperature of 85□ | Jsc (mA/cm²) | Voc (V) | F. F (%) | Efficiency (%) |
|---|---|---|---|---|
| 0h | 10.99 | 0.696 | 77.4 | 5.92 |
| 36h | 11.15 | 0.688 | 76.6 | 5.88 |
| 450h | 11.1 | 0.686 | 75.9 | 5.78 |
| 850h | 11.09 | 0.675 | 75.6 | 5.66 |
| Variation ratio (%) | 0.9 | -3 | -2.3 | -4.4 |

**[Table 11]**

| Storage time at high temperature of 85□ | Jsc (mA/cm²) | Voc (V) | F. F (%) | Efficiency (%) |
|---|---|---|---|---|
| 0h | 10.84 | 0.695 | 77.57 | 5.84 |
| 36h | 10.82 | 0.685 | 77.45 | 5.74 |
| 450h | 10.66 | 0.661 | 76.2 | 5.37 |
| 850h | 10.4 | 0.636 | 75.4 | 4.99 |
| Variation ratio (%) | -4.1 | -8.5 | -2.8 | -14.6 |

It could be appreciated that when the electric field adsorption amount was 60% or more (Tables 8 to 10), the reduction rate of efficiency was entirely reduced to about 1/2 or less as compared to the case where the electric field adsorption amount was 50% (Table 11).

The present invention has been described above with reference to preferred exemplary embodiments thereof. It will be appreciated by those skilled in the art that various modifications, changes, and substitutions can be made without departing from the essential characteristics of the present invention. Accordingly, the embodiments disclosed in the present invention and the accompanying drawings are used not to limit but to describe the spirit of the present invention. The scope of the present invention is not limited only to the embodiments and the accompanying drawings. The protection scope of the present invention must be analyzed by the appended claims and it should be analyzed that all spirits within a scope equivalent thereto are included in the appended claims of the present invention.

### <Description of symbols>

100: Working electrode
101: Working electrode substrate
102: Conductive film
103: Oxide semiconductor
104: Dye
110: Electrolyte
120: Counter electrode
121: Counter electrode substrate
122: Counter electrode material (catalyst layer/conductive material)

## Claims

1. A working electrode of a dye-sensitized solar cell comprising:
a oxide semiconductor; and
a dye having two or more anchoring groups,
wherein the two or more anchoring groups of the dye are bonded to the oxide semiconductor.

2. The working electrode of claim 1, wherein:
a ratio at which the two or more anchoring groups of the dye are bonded to the oxide semiconductor is 60% or more of an entire dye.

3. The working electrode of claim 1, wherein:
a ratio at which the two or more anchoring groups of the dye are bonded to the oxide semiconductor is 80% or more of an entire dye.

4. The working electrode of claim 1, wherein:
a ratio at which the two or more anchoring groups of the dye are bonded to the oxide semiconductor is 90% or more of an entire dye.

5. The working electrode of claim 1, wherein:
the oxide semiconductor is titanium dioxide (TiO₂).

6. The working electrode of claim 1, wherein:
the anchoring group of the dye is any one selected from the group consisting of a carboxyl group (-COOH), a cyanoacrylic acid group, an alkoxysilyl group, a pyridine group, a phosphonic acid group, a tetracyanate group, a perylene dicarboxylic acid anhydride group, a 2-hydroxylbenzonitrile group, a 8-hydroxylquinoline group, a pyridine-N-oxide group, a hydroxylpyridium group, a catechol group, a hydroxamate group, a sulfonic acid group, an acetylacetanate group, a boronic acid group, a nitro group, a tetrazole group, a rhodamine group, and a salicylic acid group.

7. The working electrode of claim 1, wherein:
the dye is a metal complex dye or an organic dye.

8. A dye-sensitized solar cell comprising:
the working electrode of claims 1 to 7.

9. A manufacturing method of a working electrode of a dye-sensitized solar cell comprising:
immersing a working electrode on which a oxide semiconductor is formed on a substrate and a conductive substrate in a dye solution bath having two or more anchoring groups, and
applying a (+) voltage to the working electrode and applying a (-) voltage to the conductive substrate so that a voltage (V) to be applied is 100V or less to allow the dye to bind to the oxide semiconductor,
wherein the two or more anchoring groups of the dye are bonded to the oxide semiconductor.

10. The manufacturing method of claim 9, wherein:
the voltage (V) to be applied to the working electrode is 10V or less.

11. The manufacturing method of claim 9, wherein:
a ratio at which the two or more anchoring groups of the dye are bonded to the oxide semiconductor is 60% or more of an entire dye.

12. The manufacturing method of claim 9, wherein:
a ratio at which the two or more anchoring groups of the dye are bonded to the oxide semiconductor is 80% or more of an entire dye.

13. The manufacturing method of claim 9, wherein:
a ratio at which the two or more anchoring groups of the dye are bonded to the oxide semiconductor is 90% or more of an entire dye.

14. The manufacturing method of claim 9, wherein:
the oxide semiconductor includes titanium dioxide (TiO₂).

15. The manufacturing method of claim 9, wherein:
the anchoring group of the dye is any one selected from the group consisting of a carboxyl group (-COOH), a cyanoacrylic acid group, an alkoxysilyl group, a pyridine group, a phosphonic acid group, a tetracyanate group, a perylene dicarboxylic acid anhydride group, a 2-hydroxylbenzonitrile group, a 8-hydroxylquinoline group, a pyridine-N-oxide group, a hydroxylpyridium group, a catechol group, a hydroxamate group, a sulfonic acid group, an acetylacetanate group, a boronic acid group, a nitro group, a tetrazole group, a rhodamine group, and a salicylic acid group.

16. The manufacturing method of claim 9, wherein:
the dye is a metal complex dye or an organic dye.
